# EUROPÄISCHE PATENTANMELDUNG

(11) **EP 1 098 201 A2**
(43) Veröffentlichungstag der Anmeldung: **09.05.2001**
(21) Anmeldenummer: 00203728.1
(22) Anmeldetag: 26.10.2000
(51) Int. Cl.: G01R 31/01

(54) **Zerstörungsfreie Prüfung von passiven Bauelementen**

(30) Priorität: 03.11.1999 DE 19952899
(71) Anmelder: Philips Corporate Intellectual Property GmbH, 52064 Aachen (DE); Koninklijke Philips Electronics N.V., 5621 BA Eindhoven (NL)
(72) Erfinder: Greuel, Georg, Dr., 52064 Aachen (DE); Van Ark, Rik, 52064 Aachen (DE)
(74) Vertreter: Volmer, Georg, Dipl.-Ing.

(57) **Zusammenfassung**

Die Erfindung betrifft eine Vorrichtung und ein Verfahren zur zerstörungsfreien Prüfung von passiven Bauelementen (1), bei denen zur Qualitätskontrolle von passiven Bauelementen (1) ein elektrisches Prüfsignal auf das Bauelement (1) angewendet wird und eine akustische Emission mittels eines Mikrofons (4) meßbar ist, welches einer Auswerteeinheit (5) zugeführt wird.

## Beschreibung

Die Erfindung betrifft eine Vorrichtung und ein Verfahren zur zerstörungsfreien Prüfung von passiven Bauelementen.

Die Qualitätskontrolle nimmt bei der Herstellung von Bauelementen eine wichtige Position ein. Zu prüfende Bauelemente werden zur Fehlerdetektion Prüfbelastungen über eine entsprechende Zeit ausgesetzt. Zur Beurteilung werden die an den Anschlüssen der Bauelementen meßbaren elektrischen Größen herangezogen. Durch Einsatz von Röntgenstrahlung oder Ultraschall lassen sich ebenfalls interne Fehler in Bauelementen feststellen.

In der US 5510719 wird ein Verfahren zur Prüfung von Kondensatoren beschrieben. Dazu wird ein Kondensator mit einer Prüfspannung geladen und unter entsprechender Temperatur über eine bestimmte Zeit belastet. Eine verbleibende Restspannung, die unter einer Schwellspannung liegt, wird als Kriterium zur Qualitätsbewertung herangezogen. Diese Restspannung wird an den Anschlüssen des Kondensators gemessen.

Bei dem beschriebenen Verfahren wird eine elektrische Antwort an den Anschlüssen des zu prüfenden Bauelements überprüft.

Nachteilig bei den bisher bekannten Verfahren ist der meist nicht unerhebliche Aufwand, der betrieben werden muß, um eine derartige Prüfung durchzuführen. Zusätzlich ist bei den bekannten Verfahren die Gefahr groß, dass qualitativ minderwertige Bauelemente durch die Prüfung gänzlich zerstört werden.

Bei der Überprüfung mittels Röntgenstrahlung oder Ultraschall wird ein weiteres, externes Prüfsignal auf das Bauelement angewendet. Dies erfordert eine zusätzliche Implementierung von beispielsweise einer Röntgenquelle oder einer Ultraschallquelle.

Aufgabe der Erfindung ist deshalb, eine Vorrichtung und ein Verfahren anzugeben, mit denen eine einfache, zuverlässige Aussage über die Fehlertoleranz des zu prüfenden Bauelements getroffen werden kann.

Die Aufgabe wird dadurch gelöst, dass eine akustische Emission eines mit einem elektrischen Prüfsignal beaufschlagten Bauelementes meßbar ist.

Das zu prüfende Bauelement wird im Rahmen der normalen Prüfung mit einem elektrischen Prüfsignal an seinen Anschlüssen beaufschlagt. Mit dieser Prüfung werden z.B. die funktionellen Grundeigenschaften, wie Widerstand oder Kapazität des Bauelements überprüft. Durch innere Defekte der Bauelemente werden diese in Schwingungen versetzt, die als akustische Emission meßbar sind. Das Frequenzspektrum bei fehlerhaften Bauelementen unterscheidet sich stark von dem Frequenzspektrum qualitativ hochwertiger Baudemente. Anhand dieses Unterschieds wird eine Entscheidung über die Qualität des überprüften Bauelementes getroffen.

Die akustische Emission ist mit einem in unmittelbarer Nähe zum Bauelement angebrachten Mikrofon meßbar. Das gemessene Signal wird einer Auswerteeinheit zugeführt, in der mittels Spektralanalyse ein Vergleich durchführbar ist, dessen Ergebnis zur Ansteuerung beispielsweise einer Sortiermaschine dient.

An die Anschlüsse der zu überprüfenden Bauelemente wird je nach Art des Bauelements eine Prüfspannung/Prüfstrom angelegt.

Besonders vorteilhaft ist die Anwendung einer Pulsspannung als Prüfsignal. Dabei werden durch das entstehende elektrische Feld Kräfte auf ruhende und bewegte Ladungsträger ausgeübt. Besonders groß ist dieser Effekt bei ferroelektrischen Werkstoffen, wie sie in einer Vielzahl von elektrischen Bauelementen verwendet werden, so z.B. in nichtlinearen Widerständen oder ferroelektrischen Kondensatoren. Ferroelektrische Werkstoffe besitzen eine hohe Dielektrizietätskonstante und reagieren auf äußere elektrische Felder mit einer Verschiebung von Domänenwänden. Dies wiederum induziert mechanische Spannungen im Material, die bei Überschreiten eines Schwellwertes zur Ausbildung von Rissen (cracks) und/oder zur Delamination führen können. Die elektrischen Eigenschaften der Bauelemente können danach durchaus noch innerhalb eines spezifischen Bereichs liegen. Latent vorhandene Schädigungen in Form von Rissen oder Delamination stellen jedoch ein potentielles Risiko für den Frühausfall des Bauelements dar. So ist z.B. in der Regel die Durchschlagfestigkeit reduziert. Bei anhaltender Belastung mit elektrischen, mechanischem oder atmosphärischen Streß (Temperatur, Feuchte) treten Fehlfunktionen auf (z.B. Kurzschluß).

Bei inneren Defekten der Bauelemente wird bei fehlerhaften Bauelementen durch die entsprechende Prüfspannung von geeigneter Form, Größe und Dauer die Rißbildung induziert. Durch die dadurch entstehende akustische Emission ist die Rißbildung und letztlich ein qualitativ minderwertiges Bauelement detektierbar. Der Einsatz von Gleich- oder Wechselspannung als Prüfspannung ist je nach Anforderungen möglich.

Bei passiven Bauelementen, die aus ferroelektrischen oder -magnetischen, elektro- oder magnetostriktiven Werkstoffe bestehen, ist mit dem erfindungsgemäßen Verfahren eine zuverlässige Aussage über die Qualität des zu prüfenden Bauelementes möglich.

Die erfindungsgemäße Anordnung und die Anwendung eines derartigen Verfahren eignet sich besonders für die Prüfung von Widerständen und Kondensatoren.

Da die Bauelemente standardmäßig mit Prüfspannungen oder Prüfströmen auf Prüfautomaten getestet werden, ist die erfindungsgemäße Anordnung und das Verfahren ohne große Aufwand in die Qualitätskontrolle oder das Prüfschema sowohl bei der Ausgangskontrolle als auch bei der Eingangskontrolle zu implementieren.

Ein Vorteil der Erfindung ist, dass ein Prüfautomat nicht zusätzlich mit speziellen Geräten zur Ansteuerung der Prüflinge ausgerüstet werden muss. Außerdem ist die akustisch messbare Emission einfach zu detektieren. Bei Prüfungen von Bauelementen, bei denen eine Teilentladung, Impedanzspektren bzw. Resonanzverschiebungen gemessen werden, erweist sich die Messung einer elektrischen Antwort an den Anschlüssen des Bauelements als erheblich aufwendiger.

Die Mittel zur Durchführung dieser Prüfung sind einfach auf bestehende Prüfautomaten zu integrieren. Beim Einsatz von Röntgenstrahlung oder Ultraschall zur Fehlerdetektion ist eine derartig einfache Implementierung nicht möglich. Einen weiteren Vorteil stellt die zerstörungsfreie Prüfung dar. Nur minderwertige Bauelemente reagieren mit einer Rißbildung oder Delamination bei der Belastung mit einem pulsartigen Prüfsignal. Qualitativ hochwertige Bauelemente werden in ihren Eigenschaften durch diese Belastung nicht beeinträchtigt.

Nachfolgend wird ein Ausführungsbeispiel anhand der Zeichnung näher erläutert.
- Fig. 1: Schematischen Aufbau einer erfindungsgemäßen Anordnung
- Fig. 2: Darstellung der akustischen Emission eines qualitativ minderwertigen Bauelements
- Fig. 3: Darstellung der akustischen Emission eines qualitativ hochwertigen Bauelements

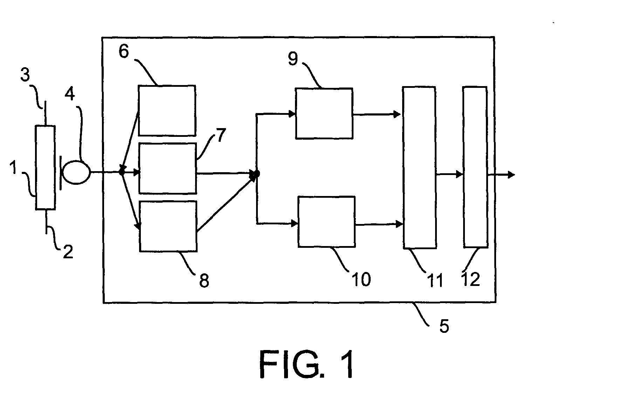

In der Figur 1 ist das Bauelement 1 mit seinen Anschlüssen 2 und 3 dargestellt, über die die elektrischen Prüfsignale in Form von Spannungspulsen zugeführt werden. Durch das elektrische Feld und die dadurch verursachten mechanischen Spannungen wird eine Verschiebung der Domänenwände hervorgerufen, die bei minderwertigen Bauelementen zu einer Rißbildung führt. Bei dieser Rißbildung wird von Bauelement 1 eine akustisch messbare Emission abgegeben. Diese akustische Emission wird vom neben dem Bauelement 1 angeordneten Mikrofon 4 aufgenommen und der Auswerteeinheit 5 zugeführt. Die Auswerteeinheit 5 beinhaltet die Ansteuereinheit 6 des Mikrofons 4, Meßverstärker 7 und Filter 8, einen Spitzenwertspeicher 9, einen Spektralanalysator 10 und eine Vergleichereinheit 11 mit Ausgangsschnittstelle 12.

Das Mikrofon 4 wird von der Ansteuereinheit 6 angesteuert. Vom Mikrofon 4 aufgenommenen Signale werden dem Meßverstärker 7 und/oder dem Filter 8 zugeführt. Das verstärkte und gefilterte Signal wird einerseits dem Spitzenwertspeicher 9 und dem Spektralanalysator 10 zugeführt. Der Spektralanalysator führt eine FFT (Fast Fourier Transformation) durch. In der Vergleichereinheit 11 wird das vorliegende Signal anhand seines Frequenzspektrums mit Frequenzspektren verglichen, die bei der akustischen Emission von qualitativ hochwertigen Bauelementen aufgenommen wurden.

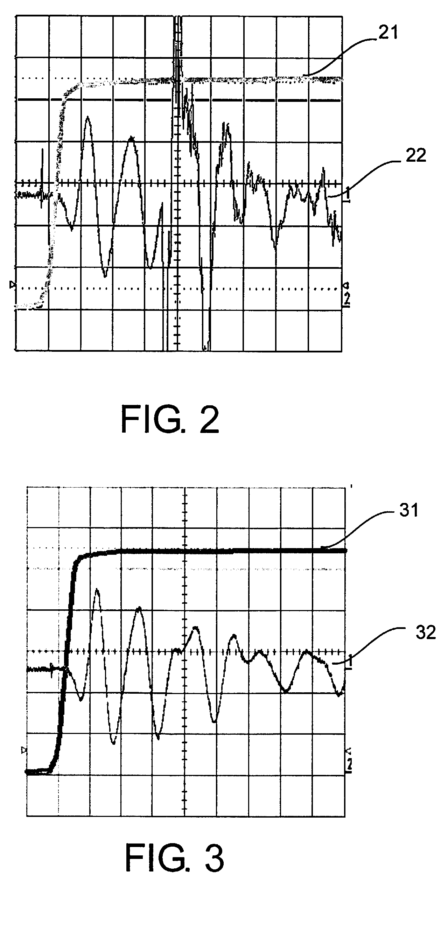

In Figur 2 ist der Verlauf der Prüfspannung 21 dem akustischen Signal 22 eines qualitativ minderwertigen Bauelements dargestellt.

In Figur 3 ist der Verlauf der Prüfspannung 31 dem akustischen Signal 32 eines qualitativ hochwertigen Bauelements dargestellt. Das akustische Signal 22 des qualitativ minderwertigen Bauelements weicht deutlich von dem akustischen Signal 32 eines hochwertigen Bauelements ab.

Diese Unterschiede werden in der Vergleichereinheit 11 detektiert und über die Ausgangsschnittstelle 12 entsprechenden Steuerungen für beispielsweise Sortiermaschinen zugeführt.

## Patentansprüche

1. Vorrichtung zur zerstörungsfreien Prüfung von Bauelementen (1),
dadurch gekennzeichnet,
dass eine akustische Emission eines mit einem elektrischen Prüfsignal beaufschlagten Bauelementes (1) meßbar ist.

2. Vorrichtung nach Anspruch 1
dadurch gekennzeichnet,
dass die akustische Emission mittels eines Mikrofons (4) meßbar ist.

3. Vorrichtung nach Anspruch 1
dadurch gekennzeichnet,
dass ein vom Mikrofon (4) aufgenommenes Meßsignal einer Auswerteeinheit (5) zuführbar ist.

4. Verfahren zur zerstörungsfreien Prüfung von Bauelementen (1),
dadurch gekennzeichnet,
dass einem passiven Bauelement (1) ein elektrisches Prüfsignal an seinen Anschlüssen (2,3) zugeführt wird und eine akustische Emission des Bauelements (1) mittels eines Mikrofons (4) gemessen und der Meßwert einer Auswerteeinheit (5) zugeführt wird.

5. Verfahren nach Anspruch 4,
dadurch gekennzeichnet,
dass dem Bauelement (1) eine Wechselspannung und/oder Gleichspannung zugeführt wird.

6. Verfahren nach einem der Ansprüche 1 bis 4,
dadurch gekennzeichnet,
dass die akustische Emission an einem mit Prüfsignalen beaufschlagten ferroelektrischen Bauelement (1) gemessen wird.

7. Verfahren nach einem der Ansprüche 1 bis 4,
dadurch gekennzeichnet,
dass die akustische Emission an einem mit Prüfsignalen beaufschlagten ferromagnetischen Bauelement (1) gemessen wird.

8. Verfahren nach einem der Ansprüche 1 bis 4,
dadurch gekennzeichnet,
dass die akustische Emission an einem mit Prüfsignalen beaufschlagten magnetostriktiven Bauelement (1) gemessen wird.

9. Verfahren nach einem der Ansprüche 1 bis 4,
dadurch gekennzeichnet,
dass die akustische Emission an einem mit Prüfsignalen beaufschlagten elektrostriktiven Bauelement (1) gemessen wird.
